# FASCICULE DE BREVET EUROPEEN

(11) **EP 1 458 095 B1**
(45) Date de publication et mention de la délivrance du brevet: **04.10.2006**
(21) Numéro de dépôt: 04300123.9
(22) Date de dépôt: 05.03.2004
(51) Int. Cl.: H03H 9/17

(54) **Procédé de réalisation d'un microrésonateur piézoélectrique accordable**
Verfahren zur Herstellung eines abstimmbaren piezoelektrischen Mikroresonators
Method of manufacturing a piezoelectric tunable microresonator

(30) Priorité: 06.03.2003 FR 0302817
(43) Date de publication de la demande: 15.09.2004
(73) Titulaire: STMicroelectronics S.A., 92120 Montrouge (FR); COMMISSARIAT A L'ENERGIE ATOMIQUE, 75752 Paris Cédex 15 (FR)
(72) Inventeur: Robert, Philippe, 38100 Grenoble (FR); Caruyer, Grégory, 38570 Goncelin (FR); Ancey, Pascal, 38420 Revel (FR); Bouche, Guillaume, 38000 Grenoble (FR)
(74) Mandataire: de Beaumont, Michel

(56) Documents cités:
- EP-A- 0 963 000
- US-A- 5 587 620
- US-A- 5 714 917
- US-A- 5 884 378

## Description

La présente invention concerne la réalisation de microrésonateurs piézoélectriques.

Un microrésonateur piézoélectrique comprend une couche piézoélectrique prise en sandwich entre deux électrodes conductrices. Un tel microrésonateur est susceptible de rentrer en résonance quand le signal appliqué entre ses électrodes est à une fréquence déterminée.

En dehors de toute influence extérieure, la fréquence de résonance d'un microrésonateur est fixée lors de sa fabrication, notamment par l'épaisseur et la nature de la couche piézoélectrique. Or pour de nombreux circuits tels que des filtres analogiques réglables, il est souhaitable de pouvoir faire varier la fréquence de résonance des microrésonateurs.

Le document US 5714917 décrit par exemple un microrésonateur à fréquence de résonance variable qui fonctionne dans des applications de modulation d'amplitude ou de phase

Un objet de la présente invention est de prévoir un procédé de fabrication d'un microrésonateur accordable tel que celui décrit précédemment.

Un autre objet de la présente invention est de prévoir un tel procédé comportant un nombre restreint d'étapes.

Un autre objet de la présente invention est de prévoir une structure de microrésonateur accordable dont les électrodes présentent des connexions facilement reliables à un plot de connexion externe ou au réseau d'interconnexions d'un circuit intégré.

Pour atteindre ces objets, la présente invention prévoit un procédé de fabrication d'un résonateur comprenant les étapes suivantes : former sur un substrat isolant une première portion d'un matériau conducteur et une deuxième portion d'un autre matériau posée sur la première portion, la deuxième portion étant constituée d'un matériau gravable sélectivement par rapport aux matériaux des autres éléments formés lors du procédé ; former une couche isolante dont la surface supérieure affleure au niveau de la partie supérieure de la deuxième portion ; former par une succession de dépôts et de gravures une poutre d'un matériau conducteur passant au-dessus de la deuxième portion, les extrémités de la poutre étant posées sur la couche isolante de part et d'autre de la deuxième portion, la surface supérieure de la deuxième portion étant découverte d'un côté et de l'autre de la poutre, une troisième portion d'un matériau piézoélectrique posée sur la poutre et une quatrième portion d'un matériau conducteur posée sur la troisième portion au-dessus de la partie de la poutre située au-dessus de la deuxième portion ; éliminer la deuxième portion.

Selon une variante de mise en oeuvre du procédé susmentionné, il est prévu durant l'étape de formation de la première portion de matériau conducteur de former une cinquième portion du même matériau conducteur que la première portion posée sur le substrat isolant et prolongeant la première portion, la couche isolante formée lors de l'étape suivante recouvrant la cinquième portion.

Selon une variante de mise en oeuvre du procédé susmentionné, la formation de la première portion et de la deuxième portion comprend les étapes suivantes : déposer une couche d'un matériau conducteur sur un substrat ; déposer sur la couche de matériau conducteur une couche d'un matériau gravable sélectivement par rapport aux matériaux des autres éléments formés lors du procédé ; et graver les deux couches de façon à former la deuxième portion superposée à la première portion.

Selon une variante de mise en oeuvre du procédé susmentionné, la formation de la première portion et de la deuxième portion comprend les étapes suivantes : déposer une première couche d'un matériau conducteur sur un substrat ; graver la première couche de matériau conducteur de façon à former la première portion ; déposer sur la deuxième portion et sur le substrat une seconde couche d'un matériau gravable sélectivement par rapport aux matériaux des autres éléments formés lors du procédé ; et graver la seconde couche de façon à former la deuxième portion posée sur la première portion.

Selon une variante de mise en oeuvre du procédé susmentionné, l'étape consistant à former la poutre, la troisième portion et la quatrième portion comprend les étapes suivantes : recouvrir la couche d'oxyde et la deuxième portion d'une première couche d'un matériau conducteur ; graver la première couche de façon à former ladite poutre posée transversalement au-dessus de la deuxième portion ; déposer une couche d'un matériau piézoélectrique au-dessus de l'ensemble de la structure comprenant ladite poutre, la deuxième portion et la couche d'oxyde ; déposer une seconde couche d'un matériau conducteur au-dessus de la couche d'un matériau piézoélectrique ; et graver la couche d'un matériau piézoélectrique et la seconde couche de façon à former la quatrième portion d'un matériau conducteur superposée à la troisième portion d'un matériau piézoélectrique.

Selon une variante de mise en oeuvre du procédé susmentionné, l'étape consistant à former la poutre, la troisième portion et la quatrième portion comprend les étapes suivantes : recouvrir la couche d'oxyde et la deuxième portion d'une première couche d'un matériau conducteur ; déposer une couche d'un matériau piézoélectrique au-dessus de la première couche ; déposer une seconde couche d'un matériau conducteur au-dessus de la couche d'un matériau piézoélectrique ; graver la seconde couche de façon à former la quatrième portion d'un matériau conducteur ; et graver la couche d'un matériau piézoélectrique et la première couche de façon à former la troisième portion d'un matériau piézoélectrique superposée à la poutre d'un matériau conducteur.

Dans un mode de mise en oeuvre du procédé susmentionné, ledit substrat isolant correspond à la couche isolante d'un circuit intégré comprise entre l'avant-dernier et le dernier niveau d'interconnexions, ladite première portion correspondant à une portion du dernier niveau d'interconnexions.

Selon une variante de mise en oeuvre du procédé susmentionné, il est prévu lors de l'étape consistant à former la poutre, la troisième portion et la quatrième portion, de former une poutre supplémentaire d'un matériau résistant sous ladite poutre.

La présente invention prévoit aussi un dispositif comportant un microrésonateur constitué d'une couche piézoélectrique en sandwich entre deux couches conductrices constituant les électrodes inférieure et supérieure du microrésonateur, le microrésonateur étant posé au-dessus d'une cavité formée dans un substrat, le fond de la cavité étant recouvert d'une couche conductrice formant une électrode de réglage, l'électrode de réglage se prolongeant par une portion conductrice enterrée dans le substrat, dans le même plan que l'électrode de réglage.

Dans un mode de mise en oeuvre du procédé susmentionné, le substrat est constitué d'une couche isolante recouvrant une couche de support, la cavité étant formée sur toute l'épaisseur de la couche isolante, l'électrode de réglage et la portion conductrice enterrée étant posées sur la couche de support.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
la figure 1 est une vue en coupe schématique d'un exemple de microrésonateur accordable que la présente invention vise à réaliser ;
la figure 2 est une vue de dessus du microrésonateur de la figure 1 ; et
les figures 3 à 11 sont des vues en coupe des structures obtenues après des étapes successives du procédé de la présente invention.

Comme cela est habituel dans la représentation des microcomposants, les diverses figures ne sont pas tracées à l'échelle.

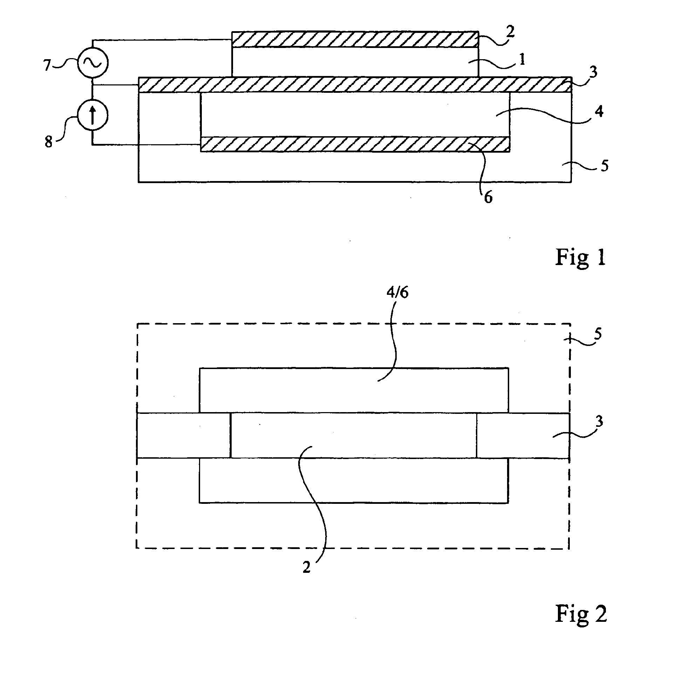

La figure 1 est une vue en coupe schématique d'un microrésonateur accordable que la présente invention vise à réaliser. Le microrésonateur est constitué d'un empilement de couches minces et comprend une couche piézoélectrique 1 en sandwich entre une électrode supérieure 2 et une électrode inférieure 3. L'électrode 3 est constituée d'une couche mince conductrice qui forme une bande s'étendant au-dessus d'une cavité 4 formée dans un substrat isolant électriquement 5, les extrémités de la bande reposant sur la surface supérieure du substrat 5. Le fond de la cavité 4 est recouvert d'une couche métallique constituant une électrode de réglage 6.

Comme l'illustre la figure 2, en vue de dessus, les bords latéraux de la bande formant l'électrode inférieure 3 sont écartés des bords de la cavité 4. La largeur de l'électrode supérieure 2 est dans cet exemple égale à la largeur de l'électrode inférieure 3.

Les électrodes 2 et 3 du microrésonateur sont reliées à des composants d'un circuit électrique. Quand le microrésonateur est excité au moyen d'une tension alternative 7 à une fréquence égale à la fréquence de résonance, on observe un phénomène de transduction électromécanique de l'énergie entre l'électrode 2 et le film piézoélectrique 1 et à l'opposé une restitution de l'énergie mécanique du film piézoélectrique 1 sous forme électrique sur l'électrode 3. Quand une tension continue 8 est appliquée entre l'électrode de réglage 6 et l'électrode inférieure 3 du microrésonateur, une contrainte est exercée sur l'électrode inférieure 3. Il en résulte que la fréquence de résonance du microrésonateur varie. Cette variation est fonction de la valeur de la tension continue 8.

Selon une variante de réalisation d'un microrésonateur selon la présente invention, une membrane de support est placée entre l'électrode inférieure et la cavité. Comme l'électrode inférieure, la membrane de support est une bande s'étendant au-dessus de la cavité. La membrane de support est par exemple en nitrure.

La présente invention vise un procédé de fabrication d'un microrésonateur tel que décrit ci-dessus en relation à la figure 1. Le procédé comprend 4 phases successives qui seront détaillées ci-après.

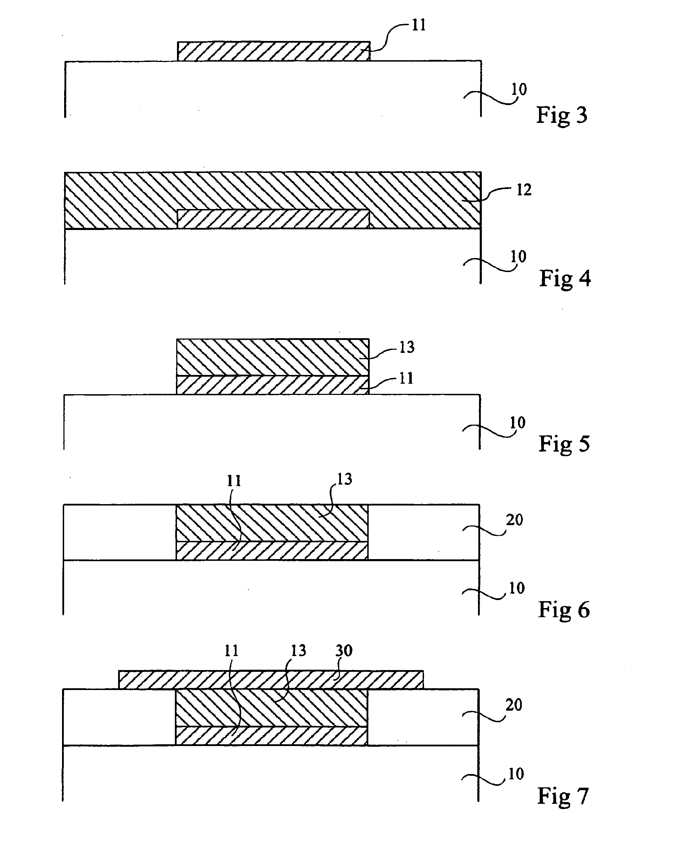

Dans une première phase illustrée en figures 3 à 5, on forme sur une couche isolante une portion conductrice et une portion de résine posée sur la portion conductrice.

Dans une première étape, illustrée en figure 3, on forme sur une couche isolante 10 une portion 11 d'un matériau conducteur, classiquement du cuivre ou de l'aluminium. La portion conductrice 11 constituera l'électrode de réglage du microrésonateur.

A l'étape suivante, illustrée en figure 4, on recouvre l'ensemble de la structure comprenant la portion conductrice 11 et la couche isolante 10 d'une couche de résine 12. On pourra par exemple utiliser une résine polymère d'un type couramment utilisé dans un procédé de réalisation de circuits intégrés lors des étapes incluant la formation d'un masque par photolithographie. Le dépôt est effectué de façon que la surface supérieure de la résine soit plane, éventuellement après un recuit.

Dans une étape suivante, illustrée en figure 5, on grave la couche de résine 12 de façon à obtenir une portion de résine 13 posée sur la portion conductrice 11. Dans le cas où la couche de résine 12 est photosensible, par exemple "positive", on pourra prévoir d'insoler les parties que l'on souhaite conserver et d'éliminer ensuite de façon classique les parties non insolées. La portion de résine 13 peut être plus petite ou plus grande que la portion conductrice 11.

De façon générale, on pourra former sur la portion conductrice 11, une portion de n'importe quel matériau susceptible d'être gravé ou éliminé sélectivement par rapport aux autres matériaux constitutifs des divers éléments formés pendant le procédé de la présente invention.

Le mode de réalisation de la première phase illustrée en figures 3 à 5 convient tout particulièrement au cas où l'on souhaite inclure un microrésonateur dans un circuit intégré. La couche isolante 10 correspondra dans ce cas à la couche isolante placée entre l'avant dernier et le dernier niveau d'interconnexions métalliques du circuit intégré. La portion conductrice 11 pourra être une portion du dernier niveau d'interconnexions.

Selon une variante de réalisation de la première phase du procédé de la présente invention, on part d'un substrat recouvert en face avant d'une couche isolante. On dépose une couche conductrice sur la couche isolante du substrat puis une couche de résine sur la couche conductrice. On grave ensuite successivement la couche de résine et la couche conductrice afin d'obtenir une portion de résine posée sur une portion conductrice. On peut utiliser le même masque pour graver les deux couches. On obtiendra alors deux portions superposées de même forme en vue de dessus. Cette variante de réalisation de la première phase s'applique tout particulièrement à la formation d'un microrésonateur comme composant discret, alors que la portion conductrice 11 n'est pas une portion d'une couche dont d'autres portions sont utilisées à d'autres fins.

Dans une deuxième phase du procédé de la présente invention, comme cela est illustré en figure 6, on dépose une couche isolante 20 sur l'ensemble de la structure constituée des portions 11, 13 et de la couche isolante 10. L'épaisseur de la couche isolante 20 déposée est au moins égale à l'épaisseur cumulée des portions 11 et 13. La couche isolante 20 est par exemple une couche d'oxyde de silicium. On effectue ensuite un polissage mécanochimique de la couche isolante 20 jusqu'à découvrir la partie supérieure de la portion de résine 13.

Dans une troisième phase du procédé de la présente invention, illustrée en figures 7 à 10, on réalise un microrésonateur comprenant une couche piézoélectrique en sandwich entre une électrode inférieure et une électrode supérieure.

Dans une première étape, illustrée en figure 7, on dépose une couche conductrice sur la structure obtenue précédemment et représentée en figure 6. L'ensemble de la structure comprenant la couche isolante 20 et la portion de résine 13 est ainsi recouverte d'une couche conductrice qui peut être constituée d'une ou de plusieurs couches superposées pouvant être par exemple en platine, en or, en aluminium, en molybdène ou en tungstène. Cette couche conductrice peut être revêtue d'une couche supérieure servant de couche d'accrochage pour l'étape suivante. La couche supérieure est composée par exemple de titane/aluminium ou de titane/platine.

On grave ensuite la couche conductrice de façon à obtenir une poutre 30 au-dessus de la portion de résine 13, les extrémités de la poutre 30 étant posées sur la couche isolante 20 de part et d'autre de la portion de résine 13. La forme de la poutre en vue de dessus, non représentée, sera prévue telle que des parties de la portion de résine 13 sont découvertes d'un côté et de l'autre de la poutre 30.

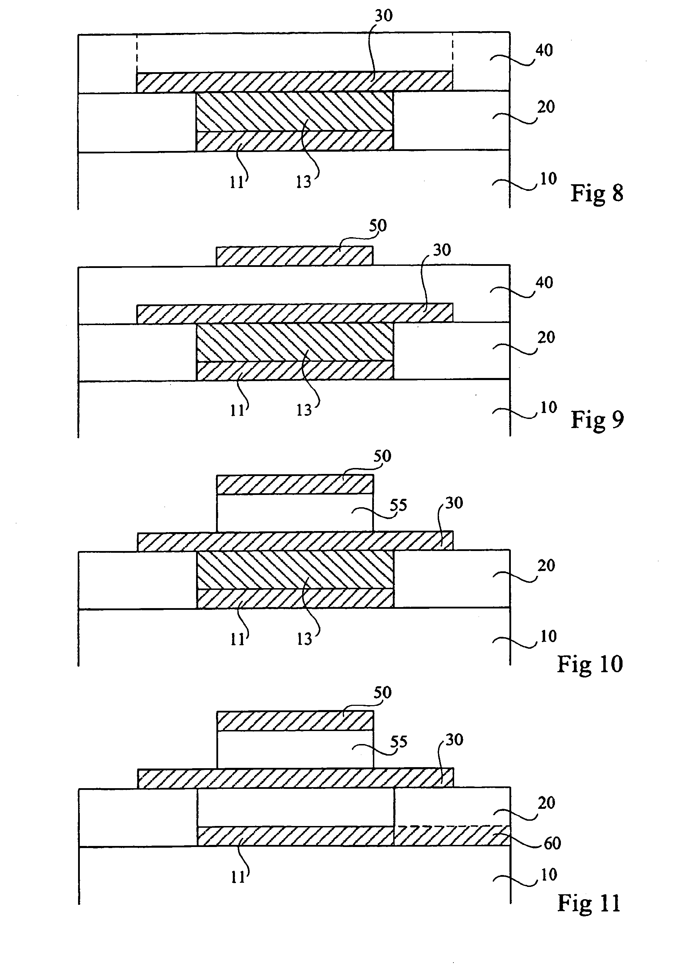

Dans une étape suivante, illustrée en figure 8, on dépose une couche 40 d'un matériau, par exemple du nitrure d'aluminium, présentant des caractéristiques piézoélectriques au moins pour les parties de la couche déposées au-dessus de la poutre 30. Les portions de la couche de nitrure d'aluminium formées au-dessus de la poutre 30 présentent des caractéristiques polycristallines. Celles formées au-dessus de la couche isolante 20 sont amorphes. D'autres matériaux susceptibles d'être utilisés pour former la couche 40 sont de l'oxyde de zinc ZnO, du "PZT" (PbZrTiO₃) ou du KNbO₃.

A l'étape suivante, illustrée en figure 9, on dépose une ou plusieurs couches conductrices, par exemple en aluminium, en platine, en or ou en or allié au chrome. On grave ensuite la couche conductrice de façon à former une portion conductrice 50 placée au-dessus de la poutre 30 et de la portion de résine 13. La largeur de la portion conductrice 50, perpendiculairement au plan de coupe de la figure 9, est au plus égale à celle de la poutre 30. De préférence, et afin de limiter les parasites dans le microrésonateur, la portion conductrice 50 est plus courte que la partie de la poutre 30 située au-dessus de la portion de résine 13.

A l'étape suivante, illustrée en figure 10, on grave la couche 40 de façon à dégager les parties de la portion de résine 13 situées en vue de dessus d'un côté et de l'autre de la poutre 30. Pour ce faire, on pourra par exemple utiliser le même masque de gravure que celui utilisé pour former la portion conductrice 50 et obtenir une portion piézoélectrique 55 de même forme que la portion conductrice 50.

Ainsi, lors de la troisième phase du procédé de la présente invention, on a formé un microrésonateur comprenant une couche piézoélectrique 55 en sandwich entre une électrode inférieure, la poutre 30, et une électrode supérieure, la portion 50.

Selon une variante de réalisation de la troisième phase du procédé de la présente invention, on dépose au-dessus de la structure illustrée en figure 6, une couche conductrice, une couche piézoélectrique, et une couche conductrice. On grave ensuite la couche conductrice supérieure afin de former l'électrode supérieure, on grave la couche piézoélectrique, puis on grave la couche conductrice inférieure pour former l'électrode inférieure. Dans ce mode de réalisation, on pourra par exemple graver la couche conductrice supérieure et la couche piézoélectrique en utilisant un premier masque et graver la couche conductrice inférieure en utilisant un second masque.

Dans une quatrième et dernière phase du procédé de la présente invention, illustrée en figure 11, on élimine complètement la portion de résine 13, y compris sous la poutre. Le procédé d'élimination de la portion de résine 13, par exemple par gravure, doit être sélectif par rapport à tous les matériaux utilisés lors des étapes précédentes.

Dans une variante du procédé de la présente invention, on prévoit de former une membrane isolante de support sous l'électrode inférieure du microrésonateur. Pour ce faire, la troisième phase du procédé comprend une étape préliminaire supplémentaire consistant à former une couche d'un matériau résistant sur la portion de résine 13 et sur la couche isolante 20. Cette couche est par exemple constituée d'une couche d'oxyde et d'une couche de nitrure. Cette couche est ensuite gravée immédiatement après la formation de la poutre 30 selon le même masque de gravure.

A titre d'exemple non limitatif, les dimensions des différents éléments du microrésonateur obtenu selon le procédé de la présente invention sont les suivantes :
- épaisseur de l'électrode de réglage : 0,5 µm
- écartement entre l'électrode de réglage et l'électrode inférieure (épaisseur de la portion de résine 13) : 1 à 2 µm
- épaisseur de l'électrode inférieure : 0,1 µm
- épaisseur de la couche piézoélectrique : 2 µm
- épaisseur de l'électrode supérieure : 0,1 µm

Afin de former des connexions aux trois électrodes du dispositif ainsi réalisé, on pourra prévoir des étapes supplémentaires dans le procédé de la présente invention.

Dans le cas où le microrésonateur fait partie d'un circuit intégré, l'électrode de réglage peut être formée sur un niveau d'interconnexions du circuit intégré. L'électrode de réglage (la portion 11) est ainsi reliée aux éléments du circuit intégré par l'intermédiaire du réseau d'interconnexions du circuit intégré. L'électrode inférieure du microrésonateur (la poutre 30) peut être reliée au réseau d'interconnexions en formant un via conducteur dans la couche isolante 20. Quant à l'électrode supérieure du microrésonateur (la portion 50), on pourra la relier au réseau d'interconnexions en prévoyant d'étendre la portion conductrice 50 par une bande placée au-dessus des couches 20 et 40. Avant de déposer la couche conductrice pour former l'électrode supérieure, on pourra par exemple former une ouverture dans la couche piézoélectrique 40 que l'on recouvrira d'un isolant et que l'on remplira ensuite d'un matériau conducteur. Le via conducteur ainsi formé sera placé au-dessus d'un autre via précédemment formé dans la couche isolante 20.

Dans le cas où le microrésonateur est un composant discret, on pourra prévoir de réaliser deux contacts en face arrière du substrat 10 en formant des plots de connexion traversant le substrat jusqu'à l'électrode de réglage et l'électrode inférieure. On pourra réaliser un contact en face avant pour accéder à l'électrode supérieure.

Un avantage du procédé de la présente invention est qu'il est possible lors de la première phase du procédé de la présente invention de former dans une même couche conductrice, une portion conductrice destinée à constituer l'électrode de réglage 11 et un prolongement 60 de cette portion conductrice, telle que représentée en pointillés sur la figure 11. Le prolongement 60 est destiné à former une connexion entre l'électrode de réglage et un autre élément de la structure. La portion de résine 13 formée lors de l'étape suivante est posée uniquement sur l'électrode de réglage 11. Le prolongement 60 est ensuite entièrement recouvert par la couche isolante 20 lors de la dernière étape de la première phase du procédé. Dans le cas où le microrésonateur est un composant discret, une telle connexion pourra par exemple être reliée à un plot de connexion en face arrière. Dans le cas où le microrésonateur est formé au-dessus d'un circuit intégré, une telle connexion pourra être reliée à un élément du circuit intégré.

Si l'on compare le dispositif obtenu par le procédé selon l'invention illustré en figure 11 au dispositif illustré en figure 1, on notera que le dispositif selon l'invention se distingue par la présence du prolongement 60 de la couche 11. Cette caractéristique du dispositif constitue un aspect de la présente invention.

Bien entendu, la présente invention est susceptible de diverses variantes et modifications qui apparaîtront à l'homme de l'art.

## Revendications

1. Procédé de fabrication d'un résonateur comprenant les étapes suivantes :
- former sur un substrat isolant (10), une première portion (11) d'un matériau conducteur et une deuxième portion (13) d'un autre matériau posée sur la première portion, la deuxième portion étant constituée d'un matériau gravable sélectivement par rapport aux matériaux des autres éléments formés lors du procédé ;
- former une couche isolante (20) dont la surface supérieure affleure au niveau de la partie supérieure de la deuxième portion ;
- former par une succession de dépôts et de gravures une poutre (30) d'un matériau conducteur passant au-dessus de la deuxième portion, les extrémités de la poutre étant posées sur la couche isolante de part et d'autre de la deuxième portion, la surface supérieure de la deuxième portion étant découverte d'un côté et de l'autre de la poutre, une troisième portion d'un matériau piézoélectrique (40) posée sur la poutre et une quatrième portion (50) d'un matériau conducteur posée sur la troisième portion au-dessus de la partie de la poutre située au-dessus de la deuxième portion ;
- éliminer la deuxième portion.

2. Procédé selon la revendication 1, comprenant durant l'étape de formation de la première portion (11) de matériau conducteur, la formation d'une cinquième portion (60) du même matériau conducteur que la première portion posée sur le substrat isolant (10) et prolongeant la première portion, la couche isolante formée lors de l'étape suivante recouvrant la cinquième portion.

3. Procédé selon la revendication 1, dans lequel la formation de la première portion (11) et de la deuxième portion (13) comprend les étapes suivantes :
- déposer une couche d'un matériau conducteur sur un substrat (10) ;
- déposer sur la couche de matériau conducteur, une couche (12) d'un matériau gravable sélectivement par rapport aux matériaux des autres éléments formés lors du procédé ; et
- graver les deux couches de façon à former la deuxième portion superposée à la première portion.

4. Procédé selon la revendication 1, dans lequel la formation de la première portion (11) et de la deuxième portion (13) comprend les étapes suivantes :
- déposer une première couche d'un matériau conducteur sur un substrat (10) ;
- graver la première couche de matériau conducteur de façon à former la première portion ;
- déposer sur la deuxième portion et sur le substrat, une seconde couche d'un matériau gravable sélectivement par rapport aux matériaux des autres éléments formés lors du procédé ; et
- graver la seconde couche de façon à former la deuxième portion posée sur la première portion.

5. Procédé selon la revendication 1, dans lequel l'étape consistant à former la poutre (30), la troisième portion (40) et la quatrième portion (50) comprend les étapes suivantes :
- recouvrir la couche d'oxyde (20) et la deuxième portion d'une première couche d'un matériau conducteur ;
- graver la première couche de façon à former ladite poutre posée transversalement au-dessus de la deuxième portion ;
- déposer une couche d'un matériau piézoélectrique au-dessus de l'ensemble de la structure comprenant ladite poutre, la deuxième portion et la couche d'oxyde ;
- déposer une seconde couche d'un matériau conducteur au-dessus de la couche d'un matériau piézoélectrique ; et
- graver la couche d'un matériau piézoélectrique et la seconde couche de façon à former la quatrième portion (50) d'un matériau conducteur superposée à la troisième portion d'un matériau piézoélectrique.

6. Procédé selon la revendication 1, dans lequel l'étape consistant à former la poutre (30), la troisième portion et la quatrième portion (50) comprend les étapes suivantes :
- recouvrir la couche d'oxyde (20) et la deuxième portion d'une première couche d'un matériau conducteur ;
- déposer une couche d'un matériau piézoélectrique au-dessus de la première couche ;
- déposer une seconde couche d'un matériau conducteur au-dessus de la couche d'un matériau piézoélectrique ;
- graver la seconde couche de façon à former la quatrième portion d'un matériau conducteur ; et
- graver la couche d'un matériau piézoélectrique et la première couche de façon à former la troisième portion d'un matériau piézoélectrique superposée à la poutre d'un matériau conducteur.

7. Procédé selon la revendication 1, dans lequel ledit substrat isolant (10) correspond à la couche isolante d'un circuit intégré comprise entre l'avant-dernier et le dernier niveau d'interconnexions, ladite première portion correspondant à une portion du dernier niveau d'interconnexions.

8. Procédé selon la revendication 1, comprenant lors de l'étape consistant à former la poutre (30), la troisième portion (40) et la quatrième portion (50), la formation d'une poutre supplémentaire d'un matériau résistant sous ladite poutre.

9. Dispositif comportant un microrésonateur constitué d'une couche piézoélectrique (1) en sandwich entre deux couches conductrices constituant les électrodes inférieure (3) et supérieure (2) du microrésonateur, le microrésonateur étant posé au-dessus d'une cavité (4) formée dans un substrat (5), le fond de la cavité étant recouvert d'une couche conductrice formant une électrode de réglage (6), **caractérisé en ce que** l'électrode de réglage se prolonge par une portion conductrice enterrée dans le substrat, dans le même plan que l'électrode de réglage.

10. Dispositif selon la revendication 9, dans lequel le substrat (5) est constitué d'une couche isolante recouvrant une couche de support, la cavité étant formée sur toute l'épaisseur de la couche isolante, l'électrode de réglage et la portion conductrice enterrée étant posées sur la couche de support.

## Claims

1. A process for manufacturing a resonator comprising the steps of:
- forming on an insulating substrate (10) a first portion (11) of a conductive material and a second portion (13) of another material on the first portion, the second portion being formed of a material selectively etchable with respect to the materials of the other elements formed during the process;
- forming an insulating layer (20) having its upper surface flush with the upper part of the second portion;
- forming by a succession of depositions and etchings a beam (30) of a conductive material above the second portion, the beam ends being on the insulating layer on either side of the second portion, the upper surface of the second portion being exposed on either side of the beam, a third portion of a piezoelectric material (40) on the beam and a fourth portion (50) of a conductive material on the third portion above the beam portion located above the second portion;
- removing the second portion.

2. The process of claim 1, comprising during the step of forming the first portion (11) of conductive material the forming of a fifth portion (60) of the same conductive material as the first portion on the insulating substrate (10) and continuing the first portion, the insulating layer formed at the next step covering the fifth portion.

3. The process of claim 1, wherein the step of forming the first portion (11) and the second portion (13) comprises the steps of:
- depositing a layer of a conductive material on a substrate (10);
- depositing on the conductive material layer a layer (12) of a material selectively etchable with respect to the materials of the other elements formed during the process; and
- etching the two layers to form the second portion superposed to the first portion.

4. The process of claim 1, wherein the step of forming the first portion (11) and the second portion (13) comprises the steps of:
- depositing a first layer of a conductive material on a substrate (10);
- etching the first conductive material layer to form the first portion;
- depositing on the second portion and on the substrate a second layer of a material selectively etchable with respect to the materials of the other elements formed during the process; and
- etching the second layer to form the second portion laid on the first portion.

5. The process of claim 1, wherein the step of forming the beam (30), the third portion (40), and the fourth portion (50) comprises the steps of:
- covering the oxide layer (20) and the second portion with a first layer of a conductive material;
- etching the first layer to form said beam transversely above the second portion;
- depositing a layer of a piezoelectric material above the structure assembly comprising said beam, the second portion and the oxide layer;
- depositing a second layer of a conductive material above the piezoelectric material layer; and
- etching the piezoelectric material layer and the second layer to form the fourth portion (50) of a conductive material superposed to the third portion of a piezoelectric material.

6. The process of claim 1, wherein the step of forming the beam (30), the third portion, and the fourth portion (50) comprises the steps of:
- covering the oxide layer (20) and the second portion with a first layer of a conductive material;
- depositing a layer of a piezoelectric material above the first layer;
- depositing a second layer of a conductive material above the piezoelectric material layer;
- etching the second layer to form the fourth portion of a conductive material; and
- etching the piezoelectric material layer and the first layer to form the third piezoelectric material portion superposed to the beam of a conductive material.

7. The process of claim 1, wherein said insulating substrate (10) corresponds to the insulating layer of an integrated circuit comprised between the penultimate and the last interconnect levels, said first portion corresponding to a portion of the last interconnect level.

8. The process of claim 1, comprising during the step of forming the beam (30), the third portion (40) and the fourth portion (50), the forming of an additional beam of a resistant material under said beam.

9. A device comprising a microresonator formed of a piezoelectric layer (1) sandwiched between two conductive layers forming lower (3) and upper (2) electrodes of the microresonator, the microresonator being above a cavity (4) formed in a substrate (5), the cavity bottom being covered with a conductive layer forming a setting electrode (6), the setting electrode extending in a conductive portion buried in the substrate, in the same plane as the setting electrode.

10. The device of claim 9, wherein the substrate (5) is formed of an insulating layer covering a support layer, the cavity being formed across the entire thickness of the insulating layer, the setting electrode and the buried conductive portion being formed on the support layer.

## Patentansprüche

1. Verfahren zur Herstellung eines Resonators, umfassend die folgenden Schritte:
- Ausbilden eines ersten Abschnitts (11) aus einem leitenden Material auf einem isolierenden Substrat (10) und eines zweiten Abschnitts (1.3) aus einem anderen Material, der auf dem ersten Abschnitt angeordnet ist, wobei der zweite Abschnitt aus einem im Verhältnis zu den Materialien der anderen während des Verfahrens ausgebildeten Elemente selektiv ätzbaren Material gebildet ist;
- Ausbilden einer Isolationsschicht (20), deren obere Oberfläche mit der Höhe des oberen Teils des zweiten Abschnitts abgeglichen ist;
- Ausbilden eines über dem zweiten Abschnitt verlaufenden Balkens (30) aus einem leitenden Material durch eine Folge von Ablagerungen und Ätzschritten, wobei die Enden des Balkens auf der Isolationsschicht auf beiden Seiten des zweiten Abschnitts angeordnet sind und die obere Oberfläche des zweiten Abschnitts auf beiden Seiten des Balkens freiliegt, ein dritter Abschnitt eines piezoelektischen Materials (40) auf dem Balken angeordnet ist und ein vierter Abschnitt (50) aus einem leitenden Material auf dem dritten Abschnitt über dem Teil des Balkens angeordnet ist, der sich über dem zweiten Abschnitt befindet; Entfernen des zweiten Abschnitts.

2. Verfahren nach Anspruch 1 , das das Ausbilden eines fünften Abschnitts (60) aus demselben leitenden Material, wie der erste auf dem isolierenden Substrat (10) angeordnete Abschnitt, während des Schrittes des Ausbildens des ersten Abschnitts (11) aus einem leitenden Material umfaßt, wodurch der ersten Abschnitt verlängert wird, wobei die während des nachfolgenden Schrittes ausgebildete Isolationsschicht den fünften Abschnitt überdeckt.

3. Verfahren nach Anspruch 1, bei dem das Ausbilden des ersten Abschnitts (11) und des zweiten Abschnitts (13) die folgenden Schritte umfaßt:
- Ablagern einer Schicht aus einem leitenden Material auf einem Substrat (10);
- Ablagern einer Schicht (12) aus einem im Verhältnis zu den Materialien der anderen während des Verfahrens ausgebildeten Elemente selektiv ätzbaren Material auf der Schicht aus einem leitendem Material; und
- Ätzen der beiden Schichten in einer Weise, daß der zweite Abschnitt den ersten Abschnitt überlagend ausgebildet wird.

4. Verfahren nach Anspruch 1, bei dem das Ausbilden des ersten Abschnitts (11) und des zweiten Abschnitts (13) die folgenden Schritte umfaßt:
- Ablagern einer ersten Schicht aus einem leitenden Material auf einem Substrat (10);
- Ätzen der ersten Schicht aus einem leitenden Material in einer Weise zum Ausbilden des ersten Abschnitts;
- Ablagern einer zweiten Schicht aus einem im Verhältnis zu den Materialien der anderen während des Verfahrens ausgebildeten Elemente selektiv ätzbaren Material auf dem ersten Abschnitt und auf dem Substrat; und
- Ätzen der zweiten Schicht in einer Weise, daß der zweite Abschnitt auf dem ersten Abschnitt angeordnet ausgebildet wird.

5. Verfahren nach Anspruch 1, bei dem der Schritt, der das Ausbilden des Balkens (30), des dritten Abschnitts (40) und des vierten Abschnitts (50) umfaßt, die folgenden Schritte umfaßt:
- Uberdecken der Oxidschicht (20) und des zweiten Abschnitts mit einer ersten Schicht aus einem leitenden Material;
- Ätzen der ersten Schicht in einer Weise, daß der Balken quer über dem zweiten Abschnitt angeordnet ausgebildet wird;
- Ablagern auf der Schicht aus einem piezoelektrischen Material über der gesamten den Balken, den zweiten Abschnitt und die Oxidschicht umfassenden Struktur;
- Ablagern einer zweiten Schicht aus einem leitenden Material über der Schicht aus einem piezoelektrischen Material; und
- Ätzen der Schicht aus einem piezoelektrischen Material und der zweiten Schicht in der Weise, daß der vierte Abschnitt (50) aus einem leitenden Material so ausgebildet wird, daß er den dritten Abschnitt aus einem piezoelektrischen Material überlagert.

6. Verfahren nach Anspruch 1, bei dem der das Ausbilden des Balkens (30), des dritten Abschnitts und des vierten Abschnitts umfassende Schritt die folgenden Schritte umfaßt:
- Überdecken der Oxidschicht (20) und des zweiten Abschnitts mit einer ersten Schicht aus einem leitenden Material;
- Ablagern einer Schicht aus einem piezoelektrischen Material auf der ersten Schicht;
- Ablagern einer zweiten Schicht aus einem leitenden Material auf der Schicht aus einem piezoelektrischen Material;
- Ätzen der zweiten Schicht in einer Weise zum Ausbilden des vierten Abschnitts aus einem leitenden Material; und
- Ätzen der Schicht aus einem piezoelektrischen Material und der ersten Schicht in einer Weise, daß der dritte Abschnitt aus einem piezoelektrischen Material den Balken aus einem leitenden Material überlagernd ausgebildet wird.

7. Verfahren nach Anspruch 1, bei dem das isolierende Substrat (10) der Isolationsschicht einer integrierten Schaltung entspricht, die sich zwischen der vorletzten und letzten Ebene von Zwischenverbindungen befindet, wobei der erste Abschnitt einem Abschnitt der letzten Ebene von Zwischenverbindungen entspricht.

8. Verfahren nach Anspruch 1, das das Ausbilden eines zusätzlichen Balkens aus einem Widerstandmaterial unter dem Balken während des das Ausbilden des Balkens (30), des dritten Abschnitts (40) und des vierten Abschnitts (50) umfassenden Schrittes umfaßt.

9. Vorrichtung, umfassend einen Mikroresonator, der eine piezoelektrische Schicht (1) umfaßt, die zwischen zwei leitende Schichten eingefügt ist, die die untere Elektrode (3) und die obere Elektrode (2) des Mikroresonators bilden, wobei der Mikroresonator über einer Kavität (4) angeordnet ist, die in einem Substrat (5) ausgebildet ist, wobei der Boden der Kavität von einer leitenden Schicht überdeckt ist, die eine Regelungselektrode (6) bildet, **dadurch gekennzeichnet, daß** die Regelungselektrode durch einen leitenden im Substrat in derselben Ebene wie die Regelungselektrode vergrabenen Abschnitt verlängert wird.

10. Vorrichtung nach Anspruch 9, bei der das Substrat (5) eine Isolationsschicht umfaßt, die eine Trägerschicht überdeckt, wobei die Kavität über die gesamte Dicke der Isolationsschicht, der Regelungsschicht und des vergrabenen leitenden Abschnitts, die auf der Trägerschicht angeordnet sind, ausgebildet ist.
